Europäisches Patentamt

European Patent Office

Office européen des brevets

(19)

(11) EP 0 584 864 B1

(12) EUROPEAN PATENT SPECIFICATION

(45) Date of publication and mention
of the grant of the patent:
**05.11.1997 Bulletin 1997/45**

(51) Int Cl.6: **H03M 13/00**, H03M 7/46,
G06F 11/10

(21) Application number: **93202408.6**

(22) Date of filing: **17.08.1993**

(54) **A hardware-efficient method and device for encoding BCH codes and in particular Reed-Solomon codes**

Hardware-effizientes Verfahren und Anordnung zur Kodierung von BCH-Kodes und insbesondere Reed-Solomon-Kodes

Procédé sobre en hardware et dispositif pour le codage de codes BCH et notamment de codes Reed-Solomon

(84) Designated Contracting States:
DE FR GB

(30) Priority: **21.08.1992 EP 92202562**

(43) Date of publication of application:
**02.03.1994 Bulletin 1994/09**

(73) Proprietor: **Philips Electronics N.V.**
**5621 BA Eindhoven (NL)**

(72) Inventors:
• **Baggen, Constant Paul Marie Jozef**
**NL-5656 AA Eindhoven (NL)**

• **Gaal, Erik Willem**
**NL-5656 AA Eindhoven (NL)**

(74) Representative: **Peters, Rudolf Johannes et al**
**INTERNATIONAAL OCTROOIBUREAU B.V.,**
**Prof. Holstlaan 6**
**5656 AA Eindhoven (NL)**

(56) References cited:
EP-A- 0 096 109     EP-A- 0 155 038
EP-A- 0 156 413     EP-A- 0 156 440
EP-A- 0 267 836     US-A- 4 413 340
US-A- 5 115 436

## Description

The invention relates to a method for encoding a regular BCH code word, said method comprising:

- presenting in a succession of clock cycles all data symbols of a code word in their associated clock cycle according to decreasing order;
- during each clock cycle calculating any data symbol's contribution to each parity symbol of a series of parity symbols.

The symbol width may be one bit, in which case the subfield of the symbols is the Galois field GF(2). Such codes are excellent for error protection against single-bit errors, such as may occur in optical fibre communication. An alternative to one-bit-symbol BCH codes are those with multibit symbols. Generally, each particular BCH code has a maximum word length. For practical purposes, shortened codes are used, in that predetermined symbols get assigned a zero value, and are not effectively stored, transmitted or otherwise used. Hereinafter, such shortened codes are also called BCH codes. Full-length BCH codes are cyclical, in that symbolwise cyclical transposition of a code word will produce another code word. Such cyclical transposition keeps the random error correctability unchanged; burst error correctability may be influenced if a shortened code is used. A subclass of multibit symbol BCH codes are Reed-Solomon codes, for which the maximum code word length is given by $N=2^m-1$, m being the number of bits per symbol. Reed-Solomon (RS) codes are excellent for protection against burst errors. A well-documented use of Reed-Solomon codes is EP A2 156 440. In the following, the embodiment is only given for Reed-Solomon codes; for other BCH-codes, the operations are effected in a comparable manner. Now, conventionally, a consumer CD-system is a decoder-only one. However, a need has been felt for a hardware-efficient encoder, particularly in view of envisaged introduction of write-once and rewritable versions of Compact Disc, and also of other applications. The invention is limited to codes that are systematic on the symbol level, wherein a conceptual dichotomy exists between data symbols and redundant or parity symbols.

## SUMMARY TO THE INVENTION

Now, amongst other things, it is an object of the invention to provide an encoder method and device for encoding BCH codes that are based on single-bit or plural-bit symbols and in particular, for encoding Reed-Solomon codes, the code words being either full-length or shortened code words. In particular, the invention envisages encoding where the series of parity symbols is interposed between a first row and a second row of data symbols. A secondary object is that the hardware should be nearly identical to that used for "normal" code words where the parity symbols are in the final positions. Especially in a CD-environment, this would allow to encode both codes with the same hardware.

Now thereto, according to a first aspect, the invention is characterized in that for said series being interposed between a first row of high order data symbols and a second row of low-order data symbols, said method comprises a serial transposing of said parity symbols with respect to said data symbols to thereby producing a sequence of said first high order row, said series, and said low order second row.

In particular, the term -serial transposing- means that generally, shift register type solutions or their emulations are used, not matrix multiplications in a processor environment. Presenting data symbols according to their associated order is very hardware-efficient, in particular, inasmuch as the intended order of an absent data symbol or of an intended parity symbol is simply realized as presentation of a zero or other dummy symbol. After all data symbols have actually been presented, their contributions to parity are fully known. A serial transposition mechanism is then only required to reorganize the content of the parity symbols to attain the intended code word configuration, wherein the parities are positioned properly.

Advantageously, the method comprises stuffing said code word with additional zero data symbols and presenting any symbol of the so stuffed code word in a rotated sequence, thereby serially transposing said series to still lower order symbol positions that follow any data symbol. Serial rotation is extremely straightforward. Moreover, no additional hardware is required, except such which executes the rotation control. The only disadvantage of this procedure that it takes relatively much time, in particular for highly shortened code words that occur in combination with the position of the parities in the middle of the code word.

Advantageously, the method comprises after presentation of a code word with dummy symbols positioned in lieu of said series and generating a transposed series of parity symbols as non-coincident with any data symbol but located at a still lower order position than any data symbol, serially back-transposing any symbol of said transposed series to the order position of said dummy symbols for addition to those dummy symbols. For code words that have the parity symbols closer to the end than roughly half the length of an unshortened code word, this usually takes less time than the previous organization. However, the backshifting requires additional hardware and additional control, both with respect to the shifting itself, and to the environment of the encoder, such as could be the case with a higher level pipeline organization.

The invention also relates to a device for implementing the method as recited.

Further advantageous aspects have been recited in dependent Claims.

It has been found that such encoder should be flexible, and require minimal hardware. As to the encoding capability in particular, inter alia, the following objects and parameters are relevant:

#1. In the compact disc convention, as well as in others, it would be desirable to use identical hardware to implement different codes provided that their parity check matrices were closely resembling each other.

#2. In particular, it would be desirable to be able to position the parity symbols on arbitrary positions within the code word, with a restriction that their positions be contiguous.

#3. Given the maximum length N of the code words in view of the symbol length chosen, and the actual length n of the code words, a first variable parameter is the shortening of the code word with respect to a non-shortened code (N-n).

#4. A second parameter is the temporal sequence wherein the data symbols are presented to the input of the device.

According to the invention, object #1 is attained through appropriate choice of parameter #4. On the other hand, for relatively short code words (parameter #3 is large) the operation is slow, in particular, just as slow as for non-shortened code words.

## BRIEF DESCRIPTION OF THE FIGURES

Various aspects and advantages of the invention are described hereinafter in detail with reference to preferred embodiments that are shown in the appended Figures, as follows:

Figures 1a-1e explain the principles underlying the encoding of the present word format;

Figure 2 shows a general set-up of an encoder system;

Figure 3 shows a shift register embodiment of the encoding;

Figure 4 shows a second shift register embodiment;

Figure 5 shows a third shift register embodiment;

Figure 6 shows a fourth shift register embodiment;

Figure 7 shows a sequencer type embodiment.

## BRIEF EXPOSE ON THE INVENTION

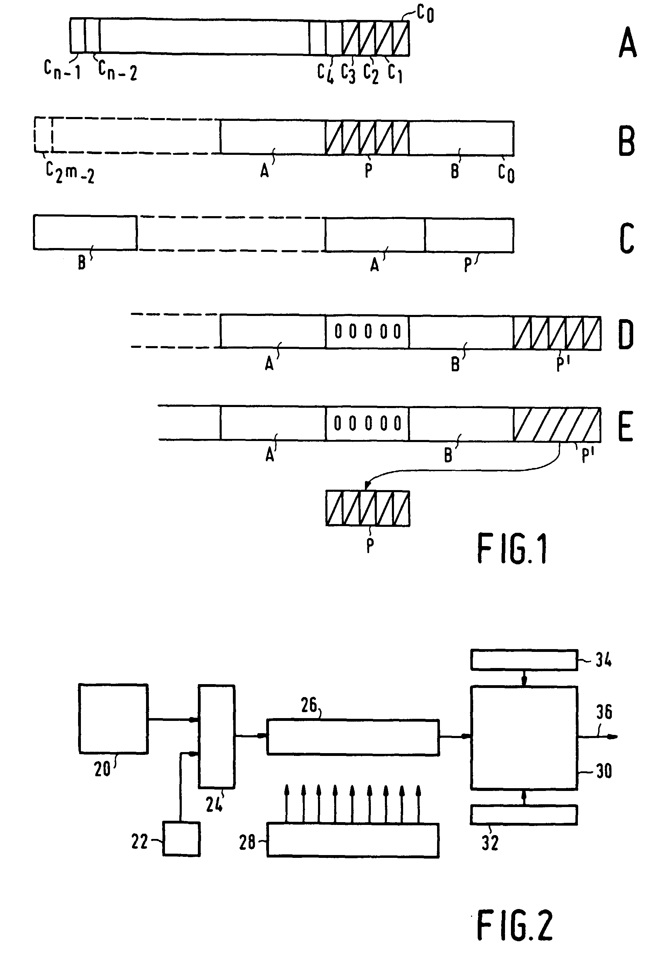

Figures 1a-1e show various code and coding configurations. Figure 1a diagrammatically shows a code word. Generally, in block codes of systematic codes, the parity symbols are in the low order position $c_j..c_0$, where $j \ll n-1$. For compact disc this is true for the so-called C1 code, but not for the C2 code. In the non-regular encoding according to the present invention, the parity positions are not the low-order positions, nevertheless the encoding is easy and straightforward, in particular without requiring parallel matrix multiplication. In particular, the latter has been found complicated and expensive, as expressed in the number of gates required.

Figure 1b diagrammatically shows a code word format that the present invention envisages to encode. For a Reed-Solomon code of m-bit symbols, the maximum length of the code word is $2^m-1$ symbols. Of the symbols numbered from $C_{2^m-2}..C_0$, the parts A and B consist of data symbols, the intermediate part P consists of parity symbols. The lengths of A, P, B in the following are arbitrary provided $A+B+P \leq 2^m-1$. As explained elsewhere, the unshortened code word is cyclical: any rotation of a code word (on symbol basis) again produces a code word. In consequence, Figure 1c illustrates a first encoding scheme for such code word: the code word is rotated such that the parity symbols P occupy the final positions. For the C2 code of Compact Disc, part B has the symbols $C_{11}..C_0$, part A has symbols $C_{27}..C_{16}$, part P has symbols $C_{15}..C_{12}$. The non-used part has 255-28=227 symbols. In this way, encoding needs 255 clock pulses, but requires very little hardware. After part B has been presented, a series of 227 dummy zeroes is presented to the encoding device.

Figure 1d shows diagrammatically a second solution to the encoding problem. Inasmuch as the symbols before part A are essentially zeroes, they do not contribute to the parities. In consequence, first part A is presented to the encoder. Next, for each intended parity symbol, a dummy symbol (e.g. zero) is presented to the encoder. Next, the part B is presented. After part B has been presented, there are P parity symbols present in notional positions P', just as in regular encoding where the parities are in the low order positions. Now, however, these positions are offset with respect to the intended parity positions, which offset is uniform with respect to the positions of all data symbols. For example, if the parity symbols had been generated one symbol period later, this only means that the offset is one symbol position higher. Now, the generating of parity symbols boils down to updating the provisional parity symbols through multiplication by $x^{-(B+P)}$ mod g(x), wherein B+P is the offset to the right in the Figure and g(x) is the generator polynomial of the code. This is effected by having the encoder shift backwards over the lengths of parts P' and B combined. In Compact Disc this means a backshift over 12+4=16 symbol positions:

$$P=(x^{-16} i(x) \bmod g(x)) \bmod g(x)=x^{-16} P' \bmod g(x)$$

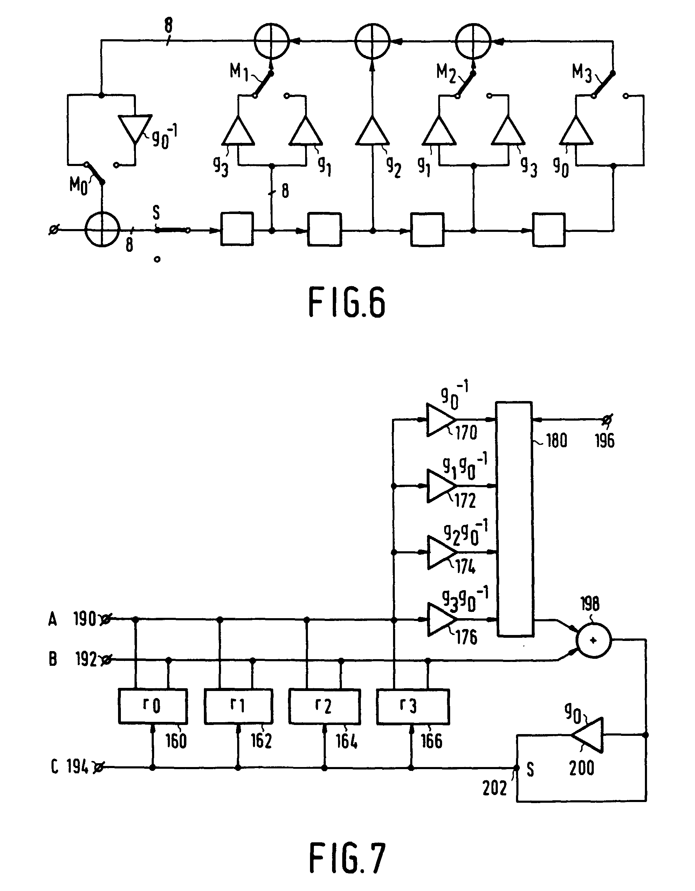

As explained hereinafter, this can be done in two ways, one with plain backshifting (Figure 5), one with use of a finite state machine (Figure 6). Both realizations have their respective advantages.

THEORETICAL BACKGROUND

The Compact Disc system has two codes C1, C2 which are both shortened Reed-Solomon (RS) codes over GF $(2^8)$, and have the same generator polynomial $g(x)=(x-1)(x-\alpha)(x-\alpha^2)(x-\alpha^3)=x^4+\alpha^{75}x^3+\alpha^{249}x^2+\alpha^{78}x+\alpha^6$ . The primitive polynomial has been chosen as $p(x)=x^8+x^4+x^3+x^2+1$, and $\alpha$ which is a root of p(x) is the primitive element. Both codes have a parity check matrix with the following structure:

$$H_n = \begin{bmatrix} 1 & 1 & \dots & 1 & 1 & 1 \\ \alpha^{n-1} & \alpha^{n-2} & \dots & \alpha^2 & \alpha & 1 \\ (\alpha^2)^{n-1} & (\alpha^2)^{n-2} & \dots & (\alpha^2)^2 & \alpha^2 & 1 \\ (\alpha^3)^{n-1} & (\alpha^3)^{n-2} & \dots & (\alpha^3)^2 & \alpha^3 & 1 \end{bmatrix}$$

where n=32 for C1 and n=28 for C2. A vector $\underline{c}$ with length n is a code word in code C1 (if n=32) or in C2 (if n=28) if and only if $\underline{c}H^T_n=\underline{0}$. The vector $\underline{c}$ consists of n components that are ordered as follows: $\underline{c} = [c_{n-1}c_{n-2} \dots c_2c_1c_0]$ , where $c_{n-1}$ is transmitted first and $c_0$ is transmitted last. This notation differs from the one conventionally used in CD publications, but covers exactly the same operations. Now, both codes have minimum distance d=5, so the code words contain four parity symbols each. In C1 they are the four low order symbols of the code word $c_3, c_2, c_1, c_0$. In C2, they are the four middle order symbols of the code word, i.e. $c_{15}, c_{14}, c_{13}, c_{12}$. Hereinafter, the order of a symbol is to be understood as its rank in the unshortened code word. Any other presentation sequence can be effected by conventional memory access technology. Furthermore, in all methods and devices contemplated hereinafter, encoding is based largely on retrocoupled shift registers that implement the generator polynomial of the code. Further, various different code word configurations are possible where the parity symbols are contiguous but other than the low order symbols of the code word only. Such -regular- code words, may form part of a full-length or shortened BCH code, or, as the case may be, of a Reed-Solomon code.

DESCRIPTION OF A PREFERRED EMBODIMENT

Figure 2 shows a general set-up of an encoder system. Block 20 symbolizes a data source that presents the data symbols according to requirements from general control device 28 (control connections not shown for brevity). Block 22 is a source for dummy symbols of which general control device 28 would know both the instant of appearance and the information content. A particularly simple solution would be that all dummy symbols have a value zero, but this is not a strict requirement. Block 24 selects, under control by device 28 the appropriate symbols from sources 20 or 22 for presentation to the retrocoupled shift register 26 that is advanced one position for each symbol received. In certain situations, for a received symbol a plurality of symbol shifts could be actuated, while also back-shifting would be feasible, as will be explained hereinafter. At the output of the shift register a random addressable memory 30 is connected that has a first separate addressing mechanism 32 for writing, and a second one 34 for reading. Upon reading, the code word symbols are presented at output 36. Likewise, block 20 could be executed as a double access memory, which has an input from the outside not shown. In case of product coding and/or interleaved coding, the output 36 after the first encoding operation could be retrocoupled to block 24, so that, in fact blocks 20, 30 could be a single one, now provided with only an output for outputting finalized code words, and an internal connection to block 24. Of course, in that case also block 22 could form a part of the random access memory.

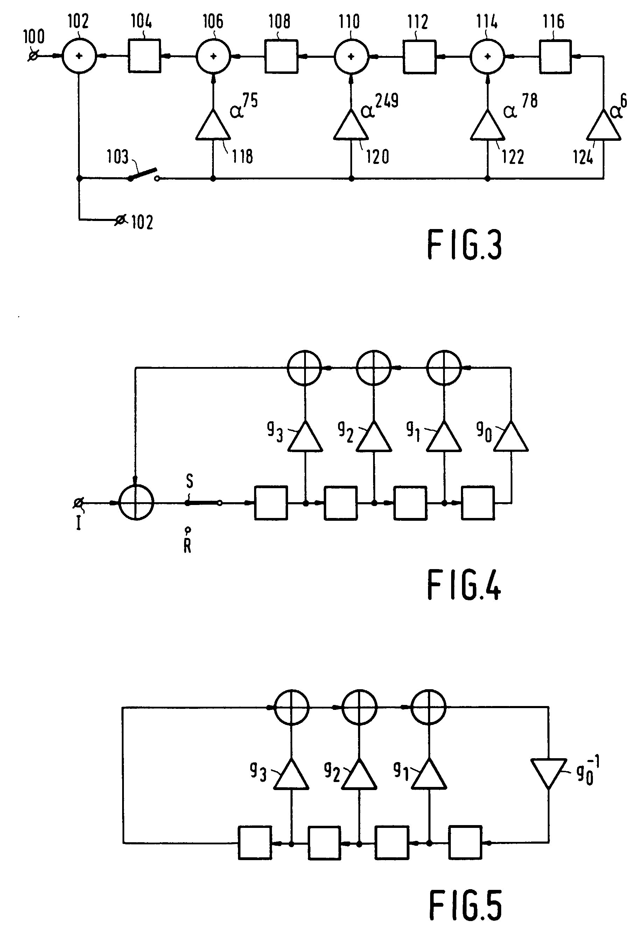

Now, Figure 3 shows a shift register arrangement for encoding the above C2 code word according to the Compact Disc standard, and for implementing the procedure discussed with respect to Figure 1c. As shown, the retrocoupled shift register comprises alternatingly storage elements and EXOR-gates 102...116: the EXOR's are internal to the shift register. A realization with the EXOR's external to the shift register will be shown later. The input is at 100. The feedback is by means of Galois field multipliers 118...124 as shown, that have their multiplying factors equal to the coefficients of the generator polynominal's terms. Now, for encoding a C2 word, the system presents symbols at the input of the circuit in the following order: first $c_{11}$, ..., $c_0$, then 227 zeroes, and finally, symbols $c_{27}$, ..., $c_{16}$. During this presentation, switch 103 is permanently closed. After symbol $c_{16}$ has been clocked in, switch 103 is opened. At that time, the shift register contains the parity symbols $c_{15}$, ..., $c_{12}$, from left to right. In consequence, shifting out these parity symbols along the shift register elements makes them available for further use. For simplicity, clocking and reset features were omitted. The correct sequence of occurrence in the code word is effected by selective memory access as explained with respect to Figure 2. The powers of $\alpha$ in the multiplier elements 118..124 are exactly those occurring in the generator polynomial of the code.

Figure 4 shows a second shift register embodiment, which has a provision for forward and backward shifting. Moreover, this has the EXOR's external to the shift register. For the forward shifting, the movement of the symbols (8 bit wide) is as indicated. The information word arrives at input I, for generating the remainder, switch S is then in the upper position. If, after the rearward shift, the correct remainder value has been produced, switch S is in the lower position. EXOR's multipliers, and delays are depicted as in Figure 3. During backward shifting, the setup is as shown in Figure 5. Now, although the Figures look quite similar (apart from a multiplier by $g_0$ that is replaced by $g_0^{-1}$), the upper three EXOR's and all four delay stages reverse their direction of operation. Therefore, Figure 6 shows a more straightforward solution that requires less hardware. Here, both EXOR's and delay stages operate unidirectionally. Forward shifting is done by putting all multiplexers in their left hand position. Backward shifting has all four multiplexers in their right hand position. The operation of switch S is as in Figures 3, 4. Three of the multipliers occur only once, only those for $g_1$, $g_3$ have to be provided two times.

Figure 7 shows a further shift register embodiment, in particular a sequencer type approach for realizing the procedure shown in Figure 1d. The set-up has three buses A(190), B(192) and C(194), four eight-bit three-state registers 160-166, one eight-bit-wide EXOR gate 198, four multipliers 170-176 with multiplication factors as indicated, one eight-bit wide five-to-one multiplexer 180 with external input 196 one eight-bit two-to-one multiplexer or switch 202, and one further multiplier 200. As earlier, no control lines or synchronization lines have been shown. The set-up operates in fact through the same multiplication factors as Figures 4, 5. If switch 202 is in the lower position, the symbol received from stage r0..r3 on lower bus 192 is added through EXOR 198 and transmitted straight back through bus 194 to its previous storage position. If the switch 202 is in the upper position, an additional multiplication factor $g_0$ is introduced. The upper input to EXOR 198 emanates from multiplexer 180. This allows to selectively multiply the received symbol by any of factors $g_0^{-1}$, $g_1 g_0^{-1}$, $g_2 g_0^{-1}$, $g_3 g_0^{-1}$. Combination with multiplier 200 yields multiplying factors 1, $g_1$, $g_2$, $g_3$, respectively. Through appropriate control for multiplexer 180 and switch 202, as well as selection of the appropriate storage element 160..166, all operations corresponding to those of Figures 4-6 can be effected. As requried, the device input can be at B, the device output at C. For simplicity, multiplexer 202 has only been drawn very schematically, with control signal S.

## Claims

1. A method for encoding a regular BCH code word, said method comprising:

    - presenting in a succession of clock cycles all data symbols of a code word in their associated clock cycle according to decreasing order;
    - during each clock cycle calculating any data symbol's contribution to each parity symbol of a series of parity symbols;

    characterized in that for said series being interposed between a first row of high order data symbols and a second row of low-order data symbols, said method comprises a serial transposing of said parity symbols with respect to said data symbols to thereby producing a sequence of said first high order row, said series, and said low order second row.

2. A method as claimed in Claim 1, and comprising stuffing said code word with additional zero data symbols and presenting any symbol of the so stuffed code word in a rotated sequence, thereby serially transposing said series to still lower order symbol positions that follow any data symbol.

3. A method as claimed in Claim 1, and comprising after presentation of a code word with dummy symbols positioned in lieu of said series and generating a transposed series of parity symbols as non-coincident with any data symbol but located at a still lower order position than any data symbol, serially back-transposing any symbol of said transposed series to the order position of said dummy symbols for addition to those dummy symbols.

4. A method as claimed in Claim 3, wherein said serially back-transposing over a particular symbol period is executed by a symbolwise emulation of a division through the reciprocal of the generator polynomial.

5. A device for encoding a regular BCH code word, said device comprising:

- input means for receiving in a succession of clock cycles all data symbols of a code word in their associated clock cycle according to decreasing order;
- calculating means for during each clock cycle calculating any data symbol's contribution to each parity symbol of a series of parity symbols, storage means for transiently storing said parity symbols developed in part, and output means fed by said storage means for outputting said parity symbols after full development thereof;

characterized in that for said series being interposed between a first row of high order data symbols and a second row of low-order data symbols, said device has transposing means for serial transposing of said parity symbols with respect to said data symbols to thereby producing a sequence of said first high order row, said series, and said low order second row.

6. A device as claimed in Claim 5, and composed of exclusively multiplying means by a fixed factor, Exclusive-OR addition means, and symbol storing means.


**Patentansprüche**

1. Verfahren zur Codierung eines regelmäßigen BCH-Codewortes, wobei das genannte Verfahren folgendes beinhaltet:

- in einer Folge von Taktzyklen alle Datensymbole eines Codeworts in ihrem zugehörigen Taktzyklus in abnehmender Reihenfolge zuführen;
- während jedes Taktzyklus den Beitrag jedes Datensymbols zu jedem Paritätssymbol einer Folge von Paritätssymbolen berechnen;

dadurch gekennzeichnet, daß das genannte Verfahren für die genannte zwischen einer ersten Zeile mit Datensymbolen hoher Ordnung und einer zweiten Zeile mit Datensymbolen niedriger Ordnung eingeschobene Folge eine serielle Transposition der genannten Paritätssymbole in bezug auf die genannten Datensymbole beinhaltet, um eine Sequenz aus der genannten ersten Zeile hoher Ordnung, der genannten Folge und der genannten zweiten Zeile niedriger Ordnung zu erzeugen.

2. Verfahren nach Anspruch 1, das außerdem das "Ausstopfen" des genannten Codewortes mit zusätzlichen Null-Datensymbolen und die Zuführung jeglichen Symbols des so "ausgestopften" Codewortes in einer rotierenden Folge beinhaltet, wodurch die genannte Folge seriell zu Symbolpositionen noch niedrigerer Ordnung umgestellt wird, die jeglichem Datensymbol folgen.

3. Verfahren nach Anspruch 1, das außerdem nach der Zuführung eines Codewortes mit Pseudosymbolen anstelle der genannten Folge und Erzeugung einer transponierten Folge von Paritätssymbolen, die nicht mit einem Datensymbol übereinstimmen, jedoch in einer Position noch niedrigerer Ordnung als jegliches Datensymbol angeordnet sind, die serielle Rückwärtransposition jeglichen Symbols der genannten transponierten Folge in die Position der Ordnung der genannten Pseudosymbole beinhaltet, um zu diesen Pseudosymbolen hinzugefügt zu werden.

4. Verfahren nach Anspruch 3, wobei die genannte serielle Rückwärtransposition über eine bestimmte Symbolperiode durch eine symbolweise Emulation einer Division durch den Kehrwert des erzeugenden Polynoms durchgeführt wird.

5. Vorrichtung zur Codierung eines regelmäßigen BCH-Codewortes, wobei die genannte Vorrichtung folgendes beinhaltet:

- Eingangsmittel, um in einer Folge von Taktzyklen alle Datensymbole eines Codeworts in ihrem zugehörigen Taktzyklus in abnehmender Reihenfolge zu empfangen;

- Berechnungsmittel, um während jedes Taktzyklus den Beitrag jedes Datensymbols zu jedem Paritätssymbol einer Folge von Paritätssymbolen zu berechnen; Speichermittel, um die genannten teilweise entwickelten Paritätssymbole vorübergehend zu speichern; und von den genannten Speichermitteln versorgte Ausgabemittel, um die genannten Paritätssymbole nach ihrer vollständigen Entwicklung auszugeben;

    dadurch gekennzeichnet, daß die Vorrichtung für die genannte zwischen einer ersten Zeile mit Datensymbolen hoher Ordnung und einer zweiten Zeile mit Datensymbolen niedriger Ordnung eingeschobene Folge Mittel zur seriellen Transposition der genannten Paritätssymbole in bezug auf die genannten Datensymbole beinhaltet, um dadurch eine Sequenz aus der genannten ersten Zeile hoher Ordnung, der genannten Folge und der genannten zweiten Zeile niedriger Ordnung zu erzeugen.

6.  Vorrichtung nach Anspruch 5, die außerdem aus Mitteln ausschließlich zur Multiplikation mit einem festgelegten Faktor, Exklusiv-ODER-Additionsmitteln und Symbolspeichermitteln besteht.

**Revendications**

1.  Procédé de codage d'un mot de code BCH régulier, ledit procédé comprenant :

    - la présentation, au cours d'une succession de cycles d'horloge, de tous les symboles de données d'un mot de code dans leur cycle d'horloge associé suivant un ordre décroissant;
    - pendant chaque cycle d'horloge, le calcul de toute contribution de symbole de données à chaque symbole de parité d'une série de symboles de parité;

    caractérisé en ce que, pour ladite série interposée entre une première rangée de symboles de données d'ordre élevé et une deuxième rangée de symboles de données d'ordre bas, ledit procédé comprend une transposition série desdits symboles de parité par rapport auxdits symboles de données afin de produire de la sorte une séquence de ladite première rangée d'ordre élevé, de ladite série, et de ladite deuxième rangée d'ordre bas.

2.  Procédé suivant la revendication 1, et comprenant le bourrage dudit mot de code avec des symboles de données nuls supplémentaires et la présentation de tout symbole du mot de code ainsi bourré en une séquence rotative, transposant de la sorte en série ladite série dans les positions de symbole d'ordre encore inférieur qui suivent tout symbole de données.

3.  Procédé suivant la revendication 1, et comprenant, après la présentation d'un mot de code avec des symboles fictifs positionnés en lieu et place de ladite série et générant une série transposée de symboles de parité ne coïncidant avec aucun symbole de données mais se trouvant dans une position d'ordre encore plus bas que n'importe quel symbole de données, la retransposition en série de tout symbole de ladite série transposée dans la position desdits symboles fictifs en vue de l'addition à ces symboles fictifs.

4.  Procédé suivant la revendication 3, dans lequel ladite transposition série sur une période de symbole particulière est exécutée par une émulation, au niveau des symboles, d'une division par la réciproque du polynôme générateur.

5.  Dispositif pour coder un mot de code BCH régulier, ledit dispositif comprenant :

    - un moyen d'entrée pour recevoir, au cours d'une succession de cycles d'horloge, tous les symboles de données d'un mot de code dans leur cycle d'horloge associé suivant un ordre décroissant;
    - un moyen de calcul pour, pendant chaque cycle d'horloge, calculer toute contribution de symbole de données à chaque symbole de parité d'une série de symboles de parité, un moyen de stockage pour stocker provisoirement lesdits symboles de parité développés en partie, et un moyen de sortie alimenté par ledit moyen de stockage pour délivrer lesdits symboles de parité après leur développement complet;

    caractérisé en ce que, pour ladite série interposée entre une première rangée de symboles de données d'ordre élevé et une deuxième rangée de symboles de données d'ordre bas, ledit dispositif comprend un moyen de transposition pour transposer en série lesdits symboles de parité par rapport auxdits symboles de données afin de produire de la sorte une séquence de ladite première rangée d'ordre élevé, de ladite série, et de ladite deuxième rangée d'ordre bas.

**6.** Dispositif suivant la revendication 5, et composé de moyens exclusivement multiplicateurs par un facteur fixe, de moyens d'addition à porte OU exclusif, et de moyens de stockage de symboles.

FIG.1

FIG.2

FIG.3

FIG.4

FIG.5

FIG.6

FIG.7